# EUROPÄISCHE PATENTSCHRIFT

(11) **EP 3 341 742 B1**
(45) Veröffentlichungstag und Bekanntmachung des Hinweises auf die Patenterteilung: **21.10.2020**
(21) Anmeldenummer: 16766231.1
(22) Anmeldetag: 22.08.2016
(51) Int. Cl.: H04B 3/46, G01R 27/26, G01R 31/58

(54) **ÜBERWACHUNGSSYSTEM, SICHERHEITSKABEL UND SCHLAUCH FÜR EIN SOLCHES UND VERFAHREN ZUM BETRIEB EINES ÜBERWACHUNGSSYSTEMS**
MONITORING SYSTEM, SAFETY CABLE AND TUBE FOR SUCH A SYSTEM, AND METHOD FOR OPERATING A MONITORING SYSTEM
SYSTÈME DE SURVEILLANCE, CÂBLE DE SÉCURITÉ ET FLEXIBLE POUR LEDIT SYSTÈME, ET PROCÉDÉ PERMETTANT DE FAIRE FONCTIONNER UN SYSTÈME DE SURVEILLANCE

(30) Priorität: 28.08.2015 DE 102015216474
(43) Veröffentlichungstag der Anmeldung: 04.07.2018
(73) Patentinhaber: LEONI Kabel GmbH, 91154 Roth (DE)
(72) Erfinder: KÖPPENDÖRFER, Erwin, 91126 Schwabach (DE); NACHTRAB, Johannes, 91575 Windsbach (DE)
(74) Vertreter: FDST Patentanwälte
(86) Internationale Anmeldenummer: PCT/EP2016/069839
(87) Internationale Veröffentlichungsnummer: WO 2017/036844

(56) Entgegenhaltungen:
- EP-B1- 0 767 918
- DE-A1- 10 203 163
- GB-A- 2 123 567
- GB-A- 2 317 707

## Beschreibung

Die Erfindung betrifft ein Überwachungssystem, ein Sicherheitskabel und einen Schlauch für ein solches Überwachungssystem sowie ein Verfahren zum Betrieb eines solchen Überwachungssystems.

Kabel, insbesondere Datenkabel, werden regelmäßig zur Ansteuerung sicherheitsrelevanter Systeme verwendet, bei denen ein Ausfall des Kabels und somit des davon abhängigen Systems zu mitunter schwerwiegenden Folgeschäden führen kann. Besonders bei Fahrassistenzsystemen für Fahrzeuge besteht die Gefahr, dass ein ausfallendes Kabel zu einem entsprechenden Ausfall des Fahrassistenzsystems führt. Bisher werden Fahrassistenzsysteme, wie beispielsweise Autopiloten oder Einparkhilfen, überwiegend als Komfortfunktion assistierend und parallel zu einer manuellen Steuerung eines Fahrzeugs eingesetzt, sodass bei einem Ausfall des Fahrassistenzsystems der Fahrer die Kontrolle über das Fahrzeug behält oder übernimmt. Im Kontext des sogenannten autonomen Fahrens soll jedoch auf eine Fahrerbeteiligung möglichst weitestgehend verzichtet werden. Da ein Eingreifen des Fahrers hierbei nicht mehr notwendig sein soll und eine aktive Überwachung des Fahrzeugs durch den Fahrer auch nicht mehr unbedingt angenommen werden kann, ist die Ausfallsicherheit eines zum autonomen Fahren und nicht lediglich als Komfortfunktion verwendeten Fahrassistenzsystems besonders relevant.

In der GB 2 317 707 A wird ein Aufbau beschrieben, bei welchem ein Kabel mit einem Oszillator verbunden ist eine Impedanz eines Schwingkreises bildet. Mit dem Aufbau kann ein Fehler des Kabels gemessen werden.

In der EP 0 767 918 B1 ist ein Kabel beschrieben, mit einem Leiter und einer Schirmung. Das Kabel weist eine Kapazität und eine Induktivität auf sowie eine Resonanzfrequenz, welche sich bei einer Beschädigung der Abschirmung ändert.

Vor diesem Hintergrund ist es eine Aufgabe der Erfindung, ein möglichst zuverlässiges Überwachungssystem anzugeben, welches als Kabel ein Sicherheitskabel aufweist oder alternativ einen Schlauch, dessen Ausfall möglichst sicher erkennbar ist. Insbesondere soll ein möglicher Ausfall vorzeitig ermittelt oder vorhergesagt werden. Desweiteren sollen ein Sicherheitskabel und ein Schlauch für das Überwachungssystem angegeben werden sowie ein Verfahren zum Betrieb des Überwachungssystems.

Die Aufgabe wird erfindungsgemäß gelöst durch ein Überwachungssystem mit den Merkmalen gemäß Anspruch 1. Weiterhin wird die Aufgabe gelöst durch ein Verfahren mit den Merkmalen gemäß Anspruch 15. Vorteilhafte Ausgestaltungen, Weiterbildungen und Varianten sind Gegenstand der Unteransprüche. Dabei gelten die Ausführungen im Zusammenhang mit dem Überwachungssystem sinngemäß auch für das Verfahren.

Das Überwachungssystem weist ein Stranggut auf, das zumindest einen Innenaufbau aufweist, entlang welchem sich eine Ausfallsensorik erstreckt, mit einem Kondensator, der zwei Elektroden aufweist, und mit einer Induktivität, die durch einen Leiter gebildet ist, der insbesondere endseitig mit einer der Elektroden elektrisch derart verbunden ist, dass ein Reihenschwingkreis ausgebildet ist. Der Kondensator sowie die zwei Elektroden erstrecken sich dabei insbesondere kontinuierlich und unterbrechungsfrei über die gesamte Länge der Leitung.

Nachfolgend werden das Stranggut speziell auch als "Sicherheitskabel" und der Innenaufbau speziell als "Leitung" bezeichnet.

Ein besonderer Vorteil der Erfindung besteht nun insbesondere darin, dass mittels des in das Sicherheitskabel integrierten Reihenschwingkreises eine Zustandsänderung und insbesondere Beschädigung des Sicherheitskabels ermittelbar ist. Das Überwachungssystem umfasst somit ein Kabel, dessen Funktionalität mittels der Ausfallelektronik überwachbar ist. Diese Ausfallelektronik ist dabei maßgeblich durch den Reihenschwingkreis gebildet, anhand dessen Veränderungen am Sicherheitskabel und damit auch an der Leitung messbar sind. Dem liegt die Überlegung zugrunde, dass der Reihenschwingkreis des Sicherheitskabels eine bestimmte Resonanzfrequenz aufweist, welche sich bei einer Beeinträchtigung oder Beschädigung verändert. Genauer gesagt weist der Kondensator einen Kapazitätswert auf und die Induktivität einen Induktivitätswert, welche maßgeblich die Resonanzfrequenz bestimmen und von der Geometrie sowie der Materialbeschaffenheit des Sicherheitskabels, insbesondere der Ausfallsensorik abhängen. Insbesondere ist die Resonanzfrequenz hierbei umgekehrt proportional zur Quadratwurzel des Produktes aus Kapazitätswert und Induktivitätswert. Beispielsweise ergibt sich dann bei einer Dehnung des Sicherheitskabels eine entsprechende Flächenänderung der Elektroden, wohingegen die Induktivität nicht beeinflusst wird und die Resonanzfrequenz entsprechend verschoben wird. Auch eine Beschädigung der Elektroden oder des Leiters hat üblicherweise eine entsprechende Auswirkung auf die Resonanzfrequenz, sodass auch auf diese Weise eine Beeinträchtigung des Sicherheitskabels detektierbar ist. Hierbei sind die Elektroden und/oder der Leiter zweckmäßigerweise derart ausgelegt, dass diese bei beispielsweise regelmäßiger mechanischer Beanspruchung des Sicherheitskabels noch vor der Leitung beschädigt werden und rechtzeitig vor einem Ausfall der Leitung ein Warnhinweis ausgegeben werden kann sowie geeigneterweise auch ausgegeben wird.

Die Ausfallsensorik dient somit vorrangig zur Überwachung der Leitung, welche insbesondere eine herkömmliche Leitung ist und eine oder mehrere Adern und/oder Aderpaare aufweist. Da sich die Ausfallsensorik entlang insbesondere der gesamten Leitung erstreckt, ist auch eine entsprechend vollständige Überwachung der Leitung gewährleistet. Grundsätzlich ist auch ein Sicherheitskabel mit mehreren Leitungen denkbar. Vorzugsweise ist die Ausfallsensorik zudem in einen Mantel oder Außenmantel des Sicherheitskabels integriert.

Die Ausfallsensorik ist insbesondere unabhängig vom Innenaufbau des Sicherheitskabels, d.h. unabhängig vom sogenannten Nutzaufbau. Mit anderen Worten: die Ausfallsensorik ist nicht in einen Innenaufbau des Sicherheitskabels integriert, sondern außerhalb des Innenaufbaus. Dabei wird unter Innenaufbau insbesondere die zumindest eine Leitung und gegebenenfalls eine Gesamtheit von Leitungen und/oder Adern verstanden, insbesondere eine Kabelseele des Sicherheitskabels. Bei einem in den Innenaufbau integriertem Detektionselement, beispielsweise einer Verschleißader, besteht grundsätzlich die Gefahr, dass bei einer Beschädigung dieses Detektionselements auch der Innenaufbau beschädigt oder negativ beeinflusst wird. Durch die unabhängige Ausgestaltung der Ausfallsensorik ist dies jedoch vorteilhaft ausgeschlossen.

Grundsätzlich ist das erfindungsgemäße Überwachungssystem auch in einer alternativen Ausgestaltung mit einem Schlauch anstelle eines Sicherheitskabels mit Leitung denkbar. Das Überwachungssystem weist dann einen Schlauch auf, entlang welchem sich eine Ausfallsensorik erstreckt, mit einem Kondensator, der zwei Elektroden aufweist, und mit einer Induktivität, die durch einen Leiter gebildet ist, der insbesondere endseitig mit einer der Elektroden elektrisch derart verbunden ist, dass ein Reihenschwingkreis ausgebildet ist. Der Kondensator sowie die zwei Elektroden erstrecken sich dabei insbesondere kontinuierlich und unterbrechungsfrei über die gesamte Länge des Schlauchs. Diese Ausgestaltungsmöglichkeit ergibt sich insbesondere aufgrund der Unabhängigkeit der Ausfallsensorik vom Innenaufbau des Schlauchs oder Kabels, d.h. allgemein eines zu überwachenden Strangguts. So wird also bei dem Überwachungssystem in einer Variante anstelle eines Sicherheitskabels mit einer oder mehreren Leitungen und/oder Adern ein Schlauch verwendet. Ein solcher Schlauch dient beispielsweise der Zuführung eines Mediums, z.B. eines Gases oder einer Flüssigkeit, und alternativ oder zusätzlich zur Einhausung einer Anzahl von Leitungen und/oder Adern. Ganz allgemein wird somit in einer Variante der Erfindung ein Stranggut bei dem Überwachungssystem verwendet, wobei sich die Ausfallsensorik dann entlang des Strangguts erstreckt. Das Stranggut ist dann beispielsweise ein Schlauch oder ein Kabel. Vorteilhafte Ausgestaltungen und Varianten sowie deren Vorteile ergeben sich analog zu den im Folgenden beschriebenen Ausgestaltungen und Varianten im Zusammenhang mit einem Sicherheitskabel als Stranggut.

In einer bevorzugten Ausgestaltung ist der Leiter zwischen den Elektroden angeordnet, wodurch der Leiter insbesondere sowohl gegen die Umgebung des Sicherheitskabels als auch gegenüber der Leitung abgeschirmt ist. Dadurch ist eine besonders zuverlässige Bestimmung der Resonanzfrequenz gewährleistet.

Bei einem Sicherheitskabel mit einer gegebenen Länge zwischen zwei Enden erstrecken sich auch die Elektroden und der Leiter zwischen diesen beiden Enden und bilden endseitig jeweils insbesondere Kontakte aus. Zur Ausbildung des Reihenschwingkreises wird dann im Zuge einer Konfektionierung des Sicherheitskabels eine der Elektroden elektrisch mit dem Leiter verbunden und zwar vorzugsweise endseitig, um eine Ausbildung des Reihenschwingkreises über die gesamte Länge zu realisieren. Am anderen Ende ist dadurch dann ein zweipoliger Anschluss ausgebildet, nämlich insbesondere durch das andere Ende des Leiters und durch ein Ende der anderen Elektrode, wobei über den zweipoligen Anschluss der Reihenschwingkreis, d.h. die Ausfallsensorik an eine Analyseeinheit anschließbar ist, zur Messung der Resonanzfrequenz.

Das Sicherheitskabel ist vorzugsweise ein Datenkabel, d.h. die Leitung ist als Datenleitung zur Übertragung von Daten ausgebildet und umfasst dazu beispielsweise mehrere Aderpaare. Ein Datenkabel wird regelmäßig zur Ansteuerung und/oder Datenübertragung zwischen einer Steuer- oder Kontrolleinheit und einem damit über das Datenkabel verbundenem System, beispielsweise einem Fahrassistenzsystem oder einer Fahrzeugkomponente, verwendet. Das Sicherheitskabel des Überwachungssystems eignet sich dann besonders als Datenkabel bei sicherheitsrelevanten Systemen, d.h. insbesondere solchen Systemen, bei denen ein Ausfall der Verbindung nicht sofort durch ein manuelles Eingreifen abgefangen wird und potentiell einen Sach- und/oder Personenschaden zur Folge hat. Dies ist insbesondere bei Systemen zum autonomen Steuern eines Fahrzeugs der Fall, beispielsweise bei einer Kamera für einen Autopiloten. Das Überwachungssystem ist daher geeigneterweise in einem Bordnetz eines Fahrzeugs verbaut, wobei mittels des Sicherheitskabels ein Fahrassistenzsystem des Fahrzeugs an das Bordnetz angeschlossen ist. Die Leitung verbindet dann das Fahrassistenzsystem mit einem Bordnetz des Fahrzeugs, beispielsweise mit einer Steuereinheit des Fahrzeugs.

Vorteilhafterweise wird das Überwachungssystem nicht oder nicht lediglich zur Ermittlung eines tatsächlichen Ausfalls der Leitung verwendet, sondern vielmehr zur Prognose eines zukünftigen Ausfalls. In diesem Zusammenhang ist besonders eine Alterungs- oder Verschleißcharakteristik der Leitung, insbesondere des gesamten Sicherheitskabels von Interesse. Diese Verschleißcharakteristik hängt prinzipbedingt von der konkreten Nutzung und Beanspruchung der Leitung ab, sodass vorab zunächst üblicherweise eine lediglich ungenaue und auf allgemeinen Erfahrungswerten beruhende Lebensdauerprognose, d.h. Aussage bezüglich der Lebensdauer der Leitung getroffen werden kann. Mittels des Überwachungssystems ist es jedoch möglich, den Verschleißprozess der Leitung von Zeit zu Zeit zu Überprüfen und die Lebensdauerprognose aufgrund der ermittelten Verschiebung der Resonanzfrequenz anzupassen. Dazu werden zunächst zweckmäßigerweise Eichmessungen für verschieden beansprucht oder gealterte Leitungen ermittelt, welche dann als Grundlage für einen Vergleich mit der bei einer jeweiligen Überwachung ermittelten Resonanzfrequenz dienen. Dadurch lässt sich dann der Verschleiß einer konkreten Leitung vorteilhaft direkt bestimmen, und zwar insbesondere unabhängig von allgemeinen Erwägungen, die vorrangig von der Nutzungszeit der Leitung ausgehen und individuelle Belastungen während der Nutzungszeit typischerweise ignorieren.

In einer geeigneten Ausgestaltung weist das Überwachungssystem eine Analyseeinheit mit einer Platine auf, an welche die Ausfallsensorik angeschlossen ist. Beispielsweise ist die Ausfallsensorik über den Anschluss des Reihenschwingkreises an geeignete Kontaktflächen der Platine angelötet. In einer alternativen, ebenfalls geeigneten Ausgestaltung weist das Sicherheitskabel einen Stecker auf, mittels dessen die Ausfallsensorik an eine insbesondere externe, d.h. nicht zum Überwachungssystem zugehörige Analyseeinheit anschließbar ist. Die Analyseeinheit ist dann beispielsweise ein Teil einer Steuereinheit eines Fahrzeugs oder insbesondere als separates Teil des Überwachungssystems an geeigneter Stelle platziert. Alternativ ist auch eine Integration der Analyseeinheit in das Sicherheitskabel denkbar. In einer Variante ist die Analyseeinheit ein externes Gerät, welches lediglich zur Ermittlung der Resonanzfrequenz an das Sicherheitskabel angeschlossen wird und ansonsten vom Sicherheitskabel getrennt ist. Der Anschluss ist dabei zweckmäßigerweise als Serviceanschluss für das Sicherheitskabel konzipiert, um dieses beispielsweise während einer Wartung an die Analyseeinheit anzuschließen.

Beim Überwachungssystem handelt es sich daher vorzugsweise um ein zumindest teilweise konfektioniertes Sicherheitskabel, das eine für den Anwendungsfall gewünschte Länge von beispielsweise einigen 10 cm bis einige wenige Meter, speziell für eine Anwendung im Kraftfahrzeug aufweist. Die eine Elektrode ist dabei mit der Induktivität leitend verbunden.

In weiteren Konfektionierungsstufen weist das konfektionierte Sicherheitskabel
- einen Stecker mit dem insbesondere zweipoligen Anschluss auf
- eine integrierte Analyseeinheit auf, die beispielsweise auf einer Platine integriert ist, wobei
- im Falle einer integrierten Analyseeinheit das konfektionierte Sicherheitskabel weiterhin vorzugsweise Signalanschlüsse, beispielsweise Steckanschlüsse eine Steckers für die Übermittlung von Ausgangssignalen der Analyseeinheit aufweist.

Ein derartiges vorkonfektioniertes Sicherheitskabel braucht daher nur noch z. B. über Steckverbinder angeschlossen zu werden, insbesondere an ein Bordnetz eines Kraftfahrzeugs.

Die Analyseeinheit dient insbesondere der Messung der Resonanzfrequenz des Reihenschwingkreises und zweckmäßigerweise auch der Ermittlung einer Veränderung oder Abweichung von einer Normalfrequenz. Vorzugsweise wird daher beim Betrieb des Überwachungssystems zunächst eine Resonanzfrequenz der Ausfallsensorik ermittelt, beispielsweise indem ein Signal mit einem breitbandigen Frequenzspektrum an den Reihenschwingkreis angelegt wird, zur Erzeugung eines Antwortspektrums, in welchem dann die Resonanzfrequenz als Frequenz mit einer maximalen Amplitude ermittelt wird. Die ermittelte Resonanzfrequenz wird daraufhin mit einer vorgegebenen Normalfrequenz verglichen, die beispielsweise durch eine vorherige Eichmessung bestimmt wurde und in einem Speicher als Referenz hinterlegt ist. Falls die Resonanzfrequenz dann um einen vorgegebenen Mindestwert abweicht, wird ein entsprechender Hinweis ausgegeben. Dieser Hinweis ist beispielsweise ein Warnton oder ein Aufleuchten einer Indikatorleuchte.

Der Leiter der Ausfallsensorik ist vorzugsweise als Draht ausgebildet, der in einer Vielzahl von Wicklungen um die Leitung herumgewickelt oder-gesponnen ist. Dadurch ist die Induktivität auf besonders einfache und platzsparende Weise als Spule ausgebildet. Insbesondere bildet der Leiter hierbei einen sogenannten D-Schirm des Sicherheitskabels. In einer ersten, besonders einfachen Ausgestaltung ist der Draht derart um den Leiter herumgesponnen, dass die Wicklungen auf Stoß liegen. Trotz eines möglichen elektrischen Kurzschlusses ist der Kontaktwiderstand zwischen benachbarten Wicklungen üblicherweise hoch genug, um einen an die Induktivität angelegten Strom weiterhin wendelförmig durch die Wicklungen zu leiten und eine Induktivität zu realisieren.

In einer vorteilhaften Variante sind die Wicklungen in Längsrichtung mit einem Abstand voneinander beabstandet, zum Einstellen eines bestimmten Induktivitätswertes der Induktivität. Der Induktivitätswert wird hierbei zweckmäßigerweise über den Abstand der Wicklungen eingestellt, d.h. insbesondere derart, dass sich im Zusammenspiel mit dem Kapazitätswert eine möglichst einfach zu messende Resonanzfrequenz ergibt, vorzugsweise eine Resonanzfrequenz im Bereich von wenigen zehn Kilohertz bis zu wenigen Megahertz.

Alternativ oder zusätzlich ist der Leiter vorteilhafterweise ein isolierter Draht, insbesondere ein Lackdraht, wodurch dann insbesondere ein Kurzschluss der Wicklungen untereinander auf einfache Weise vermieden wird. Zudem ist ein isolierter Draht auch automatisch gegenüber den Elektroden elektrisch isoliert, sodass auch hier ein Kurzschluss auf effiziente Weise verhindert ist.

In einer vorteilhaften Ausgestaltung ist zumindest eine Elektrode und sind vorzugsweise beide Elektroden jeweils als Schirmlage ausgebildet und umschließen die Leitung vollumfänglich. Die Elektroden erfüllen somit eine vorteilhafte Doppelfunktion, indem diese einerseits Elektroden des Kondensators sind, andererseits jedoch auch die Leitung gegen elektrische Signale aus der Umgebung und umgekehrt abschirmen. Ist die Leitung bereits eine geschirmte Leitung, so wird zweckmäßigerweise auf deren herkömmliche Schirmung verzichtet oder diese herkömmliche Schirmung als Elektrode verwendet, sodass das Sicherheitskabel insgesamt besonders kompakt ausgebildet ist.

Geeigneterweise sind die beiden Elektroden konzentrisch angeordnet und bilden auf diese Weise einen Zylinderkondensator mit einer inneren und einer äußeren Elektrode. Mit anderen Worten: die beiden Elektroden sind im Querschnitt kreisrund ausgebildet, mit gleichem Mittelpunkt. Dabei wird die Leitung insbesondere von beiden Elektroden umschlossen, verläuft also im Inneren der inneren Elektrode. Eine solche Ausgestaltung weist insbesondere den Vorteil auf, dass die Leitung des Sicherheitskabels dann nicht vom elektrischen Feld zwischen den Elektroden beeinflusst wird. Besonders bei der Messung der Resonanzfrequenz wird dadurch ein Übersprechen in die Leitung verhindert und dadurch auch eine mögliche Beeinträchtigung eines an die Leitung angeschlossenen Systems. Gleichzeitig bleibt andersherum vorteilhaft auch der Kapazitätswert des Kondensators von der Leitung unbeeinflusst.

In einer zweckmäßigen Variante ist zur galvanischen Trennung des Leiters von den Elektroden zwischen dem Leiter und einer oder jeweils einer der Elektroden eine Zwischenlage aus einem isolierenden Material angeordnet, insbesondere aufextrudiert. Der Leiter ist dann entsprechend gegenüber der jeweiligen Elektrode insofern galvanisch getrennt, als dass entlang des Sicherheitskabels keine elektrische Verbindung zwischen der Elektrode und dem Leiter vorliegt, sondern lediglich endseitig bei ausgebildetem Reihenschwingkreis. Der Leiter wird hierbei insbesondere durch die Zwischenlage von der Elektrode räumlich beabstandet oder ist alternativ in die Zwischenlage eingebettet.

Als isolierendes Material eignen sich alle gängigen Kunststoffe, insbesondere PU, PVC, PE oder ähnliche Materialien. Der Vorteil einer aufextrudierten Zwischenlage besteht dann insbesondere darin, dass diese durchgängig und somit besonders robust und mediendicht ausgebildet ist. Alternativ ist jedoch auch eine Bandierung oder Umwicklung zur elektrischen Isolierung geeignet. Im Falle eines zwischen den Elektroden angeordneten Leiters ist dieser dann zweckmäßigerweise von zwei Zwischenlagen eingefasst oder in einer Variante in eine gemeinsame Zwischenlage eingebettet.

In einer geeigneten Ausgestaltung ist eine der Elektroden als Geflecht aus einem leitenden Material ausgebildet, d.h. insbesondere als sogenannter C-Schirm. Ein solches Geflecht ist in mechanischer Hinsicht besonders robust und stellt zudem eine vorteilhafte Armierung des Sicherheitskabels dar. Das Geflecht ist beispielsweise aus Stahldrähten oder verzinnten Kupferdrähten gefertigt. In einer besonders geeigneten Variante ist die äußere Elektrode des Kondensators als Geflecht ausgebildet, um entsprechend alle innen liegenden Teile, insbesondere auch den Leiter und die innere Elektrode, optimal zu schützen.

In einer besonders kompakten Ausführung ist eine der Elektroden eine leitende Schicht einer mehrschichtigen Folie, die eine isolierende Trägerschicht aufweist, auf welcher die leitende Schicht aufgebracht ist. Die Elektrode ist somit insbesondere als Teil eines Folienschirms ausgebildet, der auch als B-Schirm bezeichnet wird. Bevorzugterweise ist die Folie hierbei eine metallkaschierte Folie, welche besonders dünn ist und dadurch zu einer besonders kompakten Bauform des Sicherheitskabels führt. Bei der Ausführung mit einer mehrschichtigen Folie ergibt sich zudem der Vorteil, dass die leitende Schicht als dünne Metallschicht üblicherweise brüchiger ist als die Leitung, sodass eine starke mechanische Belastung zunächst zu einer Beschädigung der entsprechenden Elektrode und Änderung der Resonanzfrequenz führt. Hieraus wird dann auf eine entsprechende Belastung der Leitung geschlossen und deren verbleibende Lebensdauer ermittelt, beispielsweise aufgrund vorheriger Testreihen, welche die Brüchigkeit der leitenden Schicht mit der verbleibenden Lebensdauer der Leitung empirisch in Verbindung bringen.

Vorteilhafterweise ist in einer Weiterbildung zur Ausbildung einer Zwischenlage zur galvanischen Trennung die Trägerschicht zum Leiter hin gewandt und zwischen diesem und der leitenden Schicht angeordnet.

Insgesamt bilden Elektroden und der Leiter bevorzugterweise eine dreigliedrige, konzentrische Anordnung. Die Elektroden und die Leiter bilden dabei nicht lediglich Elemente der Ausfallsensorik sondern zugleich insbesondere auch jeweils eine Schirmlage. Aufgrund dieser vorteilhaften Doppelfunktion ist dann auch eine besonders effiziente Abschirmung der Leitung nach außen hin realisiert. Die Elektroden sind dann in einer besonders einfachen Ausgestaltung jeweils als B- oder C-Schirm ausgebildet und der Leiter als D-Schirm. Besonders bevorzugt ist dabei ein Aufbau derart, dass sich insgesamt von innen nach außen betrachtet ein B/D/C- oder B/D/B-Schirm ergibt. Solche Anordnungen sind insbesondere einfach zu fertigen.

In einer Variante sind beide Elektroden als leitende Schichten einer mehrschichtigen Folie ausgebildet, wobei dann in der Ausgestaltung als Zylinderkondensator die beiden Trägerschichten ins Innere des Kondensators weisen und auf diese Weise jeweils eine Zwischenlage bilden. In einer Weiterbildung verläuft dann der Leiter zwischen den beiden Folien. In dieser Ausgestaltung ist das Sicherheitskabel besonders kompakt und weist im Vergleich zu einer herkömmlichen Leitung einen nur unwesentlich größeren Durchmesser auf. Dabei wird unter unwesentlich insbesondere eine Vergrößerung des Durchmessers von etwa 1 bis 10 % verstanden.

Der Kapazitätswert des Kondensators ist prinzipbedingt auch durch das zwischen den Elektroden als ein Dielektrikum angeordnete Material bestimmt. Dieses weist üblicherweise eine materialspezifische Dielektrizitätszahl, d.h. relative Dielektrizitätszahl εᵣ, auf. In einer besonders bevorzugten Ausgestaltung ist diese Dielektrizitätszahl von einem oder mehreren Umgebungsparameter abhängig, beispielsweise Temperatur oder Feuchtigkeit, wodurch dann eine entsprechende Änderung dieses Umgebungsparameters anhand einer Verschiebung der Resonanzfrequenz messbar ist. Dies ist besonders dann von Vorteil, wenn das Sicherheitskabel in einer Umgebung eingesetzt werden soll, die aufgrund dieser Umgebungsparameter zu einer entsprechenden Beanspruchung und möglicherweise Beschädigung des Sicherheitskabels und der Leitung darin führt.

Zwischen den beiden Elektroden ist dann in einer geeigneten Variante ein isolierendes Material angeordnet, das eine feuchtigkeits- und/oder temperaturabhängige Dielektrizitätszahl aufweist. Bei entsprechender Temperaturbelastung und/oder in feuchter Umgebung ändern sich dann die Dielektrizitätszahl und die Resonanzfrequenz entsprechend. Dadurch ist auf besonders einfache Weise ein Verschleiß des Sicherheitskabels durch entsprechende Umwelteinflüsse festellbar. Beispielsweise wird mittels eines Materials mit temperaturabhängiger Dielektrizitätszahl ein Brand in der Nähe des Sicherheitskabels erkannt und somit auf eine potentielle Beschädigung der Leitung geschlossen. Alternativ oder zusätzlich wird beispielsweise die Temperaturbelastung über die Zeit integriert und dann einem Berechnungsmodell zur Korrektur des Alterungsprozesses der Leitung zugeführt, um daraus eine entsprechend genauere Aussage über die verbleibende Lebenszeit der Leitung zu ermitteln. Ein besonders geeignetes Material ist beispielsweise Polyvinylchlorid, kurz PVC, welches eine sowohl temperatur- als auch feuchtigkeitsabhängige Dielektrizitätszahl aufweist.

In einer geeigneten Variante ist zwischen den beiden Elektroden ein hygroskopisches Material, insbesondere ein Superabsorber angeordnet, welches in feuchter Umgebung entsprechend Feuchtigkeit aufnimmt und dadurch eine Volumenvergrößerung erfährt. Dadurch wird dann auch die Geometrie des Kondensators verändert, was sich wiederum in einer Änderung der Resonanzfrequenz niederschlägt. Auch hierdurch sind dann vorteilhaft genauere Aussagen über den insbesondere feuchtigkeitsbedingten Verschleiß der Leitung möglich. Ein geeignetes hygroskopisches Material ist beispielsweise Polyurethan, kurz PU. Besonders geeignet ist alternativ ein Superabsorber auf der chemischen Basis von Acrylsäure und Natriumacrylat. Ein solcher Superabsorber ist besonders stark hygroskopisch und erfährt bei Wasseraufnahme eine geeignete Volumenänderung. Dadurch wird zum Einen die Dielektrizitätszahl des Materials verändert und zum Anderen auch der Abstand der beiden Elektroden zueinander. Die Effekte, welche sich durch eine Änderung der Beschaffenheit des hygroskopischen Materials einstellen sind in dieser Ausgestaltung besonders geeignet zur Realisierung des Überwachungssystems.

Das isolierende oder hygroskopische Material entspricht in einer besonders platzsparenden Ausgestaltung zweckmäßigerweise demjenigen Material, welches zur Ausbildung einer Zwischenlage oder einer Trägerschicht einer Folie verwendet. Mit anderen Worten: anstatt zusätzliches Material in den Zwischenraum zwischen den Elektroden einzubringen wird zweckmäßigerweise direkt das Material der Zwischenlage und/oder der Trägerfolie geeignet ausgewählt, d.h. mit feuchtigkeits- und/oder temperaturabhängiger Dielektrizitätszahl oder mit hygroskopischem Verhalten.

Von besonderem Vorteil ist bei dem Sicherheitskabel insbesondere, dass die Resonanzfrequenz prinzipbedingt von der Länge des Sicherheitskabels unabhängig ist, da sich der Kapazitätswert proportional und der Induktivitätswert umgekehrt proportional zur Länge verändern. Dadurch eignet sich das Sicherheitskabel besonders zur Fertigung als Meterware oder Halbzeug, mit zumindest einer Leitung, entlang welcher sich ein Kondensator erstreckt, der zwei Elektroden aufweist, sowie eine Induktivität, die durch einen Leiter gebildet ist. Bei dieser Meterware ist der Leiter insbesondere noch nicht mit einer der Elektroden verbunden; dieser Schritt erfolgt erst beim Konfektionieren des Kabels, insbesondere nach dem Ablängen auf eine bestimmte Länge. Da sich der Kondensator und die Induktivität vorteilhafterweise kontinuierlich entlang der Leitung erstrecken, ist das Sicherheitskabel an beliebigen Stellen ablängbar und anschließend ein Reihenschwingkreis ausbildbar. Um den Reihenschwingkreis auszubilden wird dann zweckmäßigerweise ein Ende des Leiters mit einem Ende einer der Elektroden verbunden, beispielsweise verlötet oder vercrimpt.

Insbesondere hinsichtlich der EMV-Verträglichkeit des Überwachungssystems erfolgt die Ermittlung der Resonanzfrequenz vorzugsweise nicht im regulären Betrieb des Sicherheitskabels, also beispielsweise bei der Übertragung von Daten mittels der Leitung, da diese Übertragung durch ein an den Reihenschwingkreis angelegtes Testsignal unter Umständen negativ beeinflusst wird. Stattdessen wird die Resonanzfrequenz zweckmäßigerweise in regelmäßigen oder unregelmäßigen Intervallen ermittelt, beispielsweise im Zuge einer insbesondere wiederkehrenden Wartung. Die Überwachung des Sicherheitskabels, insbesondere der Leitung erfolgt somit nicht kontinuierlich, sondern nur zu bestimmten Zeiten und beispielsweise im Abstand mehrerer Wochen, Monate oder Jahre.

Nachfolgend wird ein Ausführungsbeispiel der Erfindung anhand einer Zeichnung näher erläutert. Darin zeigen jeweils schematisch:
- Fig. 1: ein Fahrzeug mit einem Überwachungssystem,
- Fig. 2: ein Sicherheitskabel für das Überwachungssystem in einer Seitenansicht,
- Fig. 3: das Sicherheitskabel in einer Querschnittansicht, und
- Fig. 4: ein Ersatzschaltbild des Überwachungssystems.

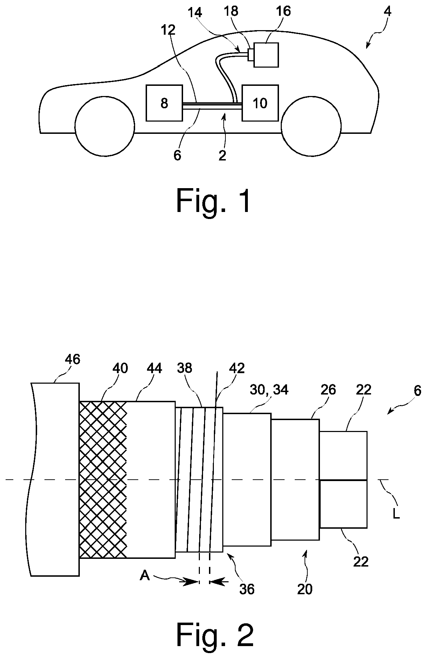

Fig. 1 zeigt ein Überwachungssystem 2, welches in einem Fahrzeug 4 verbaut ist. Das Überwachungssystem 2 weist ein Sicherheitskabel 6 auf, welches in dem hier gezeigten Ausführungsbeispiel ein Fahrassistenzsystem 8 des Fahrzeugs 4 mit einer Steuereinheit 10 des Fahrzeugs 4 zwecks Datenübertragung verbindet. Das Fahrassistenzsystem 8 wird insbesondere für einen autonomen Fahrmodus des Fahrzeugs 4 verwendet; die mittels des Sicherheitskabels 6 hergestellte Verbindung ist somit eine sicherheitsrelevante Verbindung, deren möglicher Ausfall vorzugsweise vorhergesagt wird, um Folgeschäden zu vermeiden. Um den Verschleiß des Sicherheitskabels 6 bestimmen oder ermitteln zu können und eine Prognose über dessen noch verbleibende Lebensdauer aufstellen zu können, weist das Überwachungssystem 2 eine Ausfallsensorik 12 auf, welche sich entlang des Sicherheitskabels 6 erstreckt und über einen Anschluss 14 mit einer Analyseeinheit 16 des Überwachungssystems 2 verbunden ist. In dem hier gezeigten Ausführungsbeispiel ist der Anschluss 14 mit einem Stecker 18 ausgestattet, mittels dessen die Ausfallsensorik 12 anschließbar ist. In einer hier nicht gezeigten Alternative ist die Analyseeinheit 16 dagegen ein Teil des Überwachungssystems 2, der Anschluss 14 ist dann beispielsweise an eine Platine dieser Analyseeinheit 16 angelötet. In einer weiteren, nicht gezeigten Variante ist die Analyseeinheit 16 in die Steuereinheit 10 des Fahrzeugs integriert.

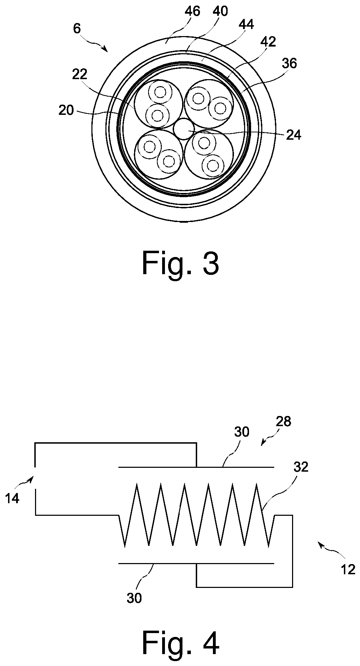

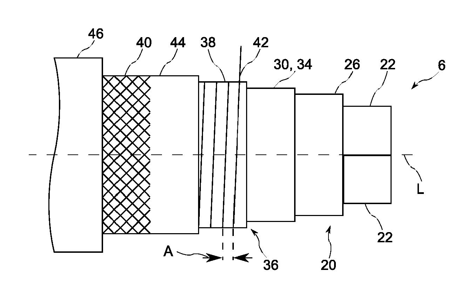

Die Figuren 2 und 3 zeigen das Sicherheitskabel 6 aus Fig. 1 als Meterware in einer Seitenansicht, beziehungsweise in einer Querschnittansicht. Das Sicherheitskabel 6 weist hier eine zentral angeordnete Leitung 20 auf, welche mehrere, hier vier Aderpaare 22 umfasst. Die Leitung 20 ist somit insbesondere als 4-kanalige Datenleitung ausgebildet. Insofern stellt die Leitung 20 insbesondere ein herkömmlicherweise verwendetes Datenkabel dar. Die Aderpaare 22 der Leitung 20 sind um eine Zugentlastung 24 herum gruppiert und von einem gemeinsamen Leitungsmantel 26 umgeben. Um die Leitung 20 herum sind nun weitere Lagen und/oder Schichten angeordnet, zur Ausbildung der Ausfallsensorik 12.

Ein Ersatzschaltbild dieser Ausfallsensorik 12 des Sicherheitskabels 6 ist in Fig. 4 dargestellt. Daraus ist erkennbar, dass die Ausfallsensorik 12 ganz allgemein einen Kondensator 28 mit zwei Elektroden 30 sowie eine Induktivität 32 aufweist, welche in Serie zu einem Reihenschwingkreis geschaltet sind. Dabei ist die Induktivität 32 in dem hier beschriebenen Ausführungsbeispiel innerhalb des Kondensators 28 angeordnet. Denkbar ist jedoch auch eine alternative Positionierung anderswo. Zur Ausbildung des Reihenschwingkreises ist die Induktivität 32 mit einer der Elektroden 30 elektrisch verbunden. Die Ausfallsensorik 12 weist dann einen zweipoligen Anschluss 14 auf, welcher an eine Analyseneinheit 16 anschließbar ist.

Die genaue Ausgestaltung und Anordnung der einzelnen Elemente der Ausfallsensorik 12 wird im Folgenden anhand von Fig. 2 und 3 in Kombination mit den Bezeichnungen des Ersatzschaltbildes der Fig. 4 genauer erläutert. In den Fig. 2 und 3 ist der Kondensator 28 als Zylinderkondensator angeordnet, mit zwei zueinander konzentrisch angeordneten Lagen aus einem leitenden Material. Eine der beiden Elektroden 30 ist dabei eine innere Elektrode 30, die als leitende Schicht 34 einer mehrschichtigen Folie 36 ausgebildet ist. Diese ist hier als metallkaschierte Folie ausgebildet und weist als eine weitere Schicht eine Trägerschicht 38 auf, die aus einem isolierenden Material gefertigt ist, beispielsweise einem Kunststoff, und auf welcher die leitende Schicht 34 aufgebracht ist. Dabei ist die Folie 36 in der hier gezeigten Ausführungsvariante derart orientiert, dass die leitende Schicht 34 nach innen weist und die Trägerschicht 38 nach außen hin orientiert ist. Weiterhin ist die leitende Schicht 34 durchgängig ausgeführt, wodurch die mehrschichtige Folie 36 einen Folienschirm, auch als b-Schirm bezeichnet, bildet, d.h. die Elektrode 30 bildet gleichzeitig eine Schirmlage für die Leitung 20.

Die andere, d.h. hier die äußere Elektrode 30 ist in dem gezeigten Ausführungsbeispiel als Geflecht 40 ausgebildet, welches vollumfänglich um die Leitung 20 und die Folie 36 herum angeordnet ist. Das Geflecht 40 bildet somit nicht nur eine der Elektroden 30, sondern zugleich auch einen weiteren Schirm, nämlich einen sogenannten C-Schirm für die Leitung 20. In einer nicht gezeigten Variante ist auch die äußere Elektrode 30 beispielsweise als Teil einer Folienschirmung, d.h. eines B-Schirms ausgebildet. Insgesamt ergibt sich durch die Ausbildung der beiden Elektroden 30 als durchgängige Lagen aus leitendem Material und deren konzentrischer Anordnung um die Leitung 20 herum eine vorteilhafte Doppelschirmung.

Zwischen den beiden Elektroden 30 ist ein Leiter 42 als Induktivität 32 um die Leitung 20 herumgewickelt. Der Leiter 42 ist hierbei als Draht ausgebildet und in einer Vielzahl von Wicklungen aufgewickelt, wodurch die Induktivität 32 als Spule ausgebildet ist. Dabei ist in dem hier gezeigten Ausführungsbeispiel, wie auch in Fig. 4 verdeutlicht, die Induktivität 32 zwischen den Elektroden 30 angeordnet. Generell ist es jedoch auch denkbar die Induktivität 32 nicht im Zwischenraum zwischen den beiden Elektroden 30 anzuordnen, sondern außerhalb davon. Die Wicklungen sind in einem bestimmten Abstand A zu einander ausgebildet, wodurch insbesondere ein bestimmter Induktivitätswert der Induktivität 32 eingestellt ist. In einer nicht gezeigten Alternative sind die Wicklungen dagegen nicht beabstandet und auf Stoß, das heißt aneinander liegend gewickelt.

Um einen Kurzschluss zwischen Induktivität 32 und Elektroden 30 entlang des Sicherheitskabels 6 zu vermeiden, ist zwischen dem Geflecht 40 und dem Draht 42 eine Zwischenlage 44 angeordnet, die hier insbesondere ein aufextrudierter Zwischenmantel des Sicherheitskabels 6 ist. Zur galvanischen Trennung des Leiters 42 bezüglich der leitenden Schicht 34 ist die mehrschichtige Folie 36 wie oben bereits erwähnt derart orientiert, dass die Trägerschicht 38 zum Leiter 42 hinweist und die leitende Schicht 34 nach innen orientiert ist, sodass der Leiter 42 also auf der Trägerschicht 38 angeordnet ist und diese eine weitere Zwischenlage bildet. Desweiteren weist das Sicherheitskabel 6 einen Außenmantel 46 auf, welcher die Leitung 20 und die Ausfallsensorik 12 umgibt und zusammenfasst, insbesondere zum Schutz gegen Umgebungseinflüsse.

Zur Überwachung wird eine Resonanzfrequenz des Reihenschwingkreises ermittelt, welche im Wesentlichen durch einen Kapazitätswert des Kondensators 28 und einen Induktivitätswerts der Induktivität 32 gegeben ist. Je nach Belastung, Alterung und Verschleiß des Sicherheitskabels wird entsprechend auch die Ausfallsensorik 12 beeinflusst und es ergeben sich Veränderungen der Geometrie und oder Materialbeschaffenheit, welche sich in Änderungen des Induktivitätswertes und des Kapazitätswertes niederschlagen, d.h. letztendlich eine Änderung der Resonanzfrequenz verursachen. Dabei ist der Kapazitätswert des Kondensators 28 besonders durch das innerhalb der beiden Elektroden 30 angeordnete Material bestimmt, nämlich hier das Material der Zwischenlage 44 sowie der Trägerschicht 38. Um mittels der Ausfallsensorik 12 dann beispielsweise eine Beanspruchung des Sicherheitskabels 6 durch hohe Temperaturen oder durch Feuchtigkeit zu ermitteln, ist die Zwischenlage 44 oder die Trägerschicht 38 oder sind beide aus einem Material gefertigt, welches eine temperatur- und/oder feuchtigkeitsabhängige Dielektrizitätszahl aufweist. Bei einer entsprechenden Temperaturerhöhung oder dem Vorliegen von Feuchtigkeit in der Umgebung des Sicherheitskabels 6 verändert sich dann die Dielektrizitätszahl des Materials oder der Materialien im Zwischenraum zwischen den beiden Elektroden 30, sodass sich auch der Kapazitätswert des Kondensators 28 verändert. Dadurch verändert sich dann insgesamt die Resonanzfrequenz des Reihenschwingkreises, sodass die entsprechende Beeinträchtigung des Sicherheitskabels 6 durch Ermittlung der Resonanzfrequenz festgestellt wird.

Die Fig. 2 und 3 zeigen das Sicherheitskabel 6 zunächst als Meterware, bei welcher der Reihenschwingkreis noch nicht ausgebildet ist. Mit anderen Worten: die Elektroden 30 und der Leiter 42 sind in dieser Ausgestaltung noch nicht miteinander verbunden. Zur Ausbildung des Reihenschwingkreises und somit der Ausfallsensorik 12 wird dann nach einem Ablängen des Sicherheitskabels 6 auf eine bestimmt Länge der Leiter 42 an einem Ende des Sicherheitskabels 6 mit einer der Elektroden 30 verbunden, beispielsweise verlötet oder an dieser festgecrimpt. Am anderen Ende des Sicherheitskabels 6 wird dann durch die andere Elektrode 30 und das entsprechend andere Ende des Leiters 42 der Anschluss 14 gebildet, welcher in einer Variante dann zusätzlich mit einem Stecker verbunden wird. Durch diese Konfektionierung wird aus dem Sicherheitskabel 6 als Meterware das Überwachungssystem 2 gebildet.

### Bezugszeichenliste

- 2: Überwachungssystem
- 4: Fahrzeug
- 6: Sicherheitskabel
- 8: Fahrassistenzsystem
- 10: Steuereinheit
- 12: Ausfallelektronik
- 14: Anschluss
- 16: Analyseeinheit
- 18: Stecker
- 20: Leitung
- 22: Aderpaar
- 24: Zugentlastung
- 26: Leitungsmantel
- 28: Kondensator
- 30: Elektrode
- 32: Induktivität
- 34: leitende Schicht
- 36: mehrschichtige Folie
- 38: Trägerschicht
- 40: Geflecht
- 42: Leiter
- 44: Zwischenlage
- 46: Außenmantel
- A: Abstand
- L: Längsrichtung

## Patentansprüche

1. Überwachungssystem (2) mit einem Stranggut (6), das einen Innenaufbau aufweist, entlang welchem sich eine Ausfallsensorik (12) erstreckt, mit einem Kondensator (28), der zwei Elektroden (30) aufweist, und mit einer Induktivität (32), die durch einen Leiter (42) gebildet ist, der mit einer der Elektroden (30) elektrisch derart verbunden ist, dass ein Reihenschwingkreis ausgebildet ist,
**dadurch gekennzeichnet,**
**dass** die beiden Elektroden (30) jeweils als Schirmlage ausgebildet sind und den Innenaufbau vollumfänglich umschließen.

2. Überwachungssystem (2) nach dem vorhergehenden Anspruch,
**dadurch gekennzeichnet,**
**dass** der Leiter (42) zwischen den Elektroden (30) angeordnet ist.

3. Überwachungssystem (2) nach einem der vorhergehenden Ansprüche,
**dadurch gekennzeichnet,**
**dass** dieses eine Analyseeinheit (16) mit einer Platine aufweist, an welche die Ausfallsensorik (12) angeschlossen ist, oder dass das Sicherheitskabel (6) einen Stecker (18) aufweist, mittels dessen die Ausfallsensorik (12) an eine Analyseeinheit (16) anschließbar ist, zur Messung einer Resonanzfrequenz des Reihenschwingkreises.

4. Überwachungssystem (2) nach einem der vorhergehenden Ansprüche,
**dadurch gekennzeichnet,**
**dass** der Leiter (42) als Draht ausgebildet ist, der in einer Vielzahl von Wicklungen um den Innenaufbau herumgewickelt oder-gesponnen ist.

5. Überwachungssystem (2) nach dem vorhergehenden Anspruch,
**dadurch gekennzeichnet,**
**dass** die Wicklungen in einer Längsrichtung (L) mit einem Abstand (A) voneinander beabstandet sind, zum Einstellen eines bestimmten Induktivitätswertes der Induktivität.

6. Überwachungssystem (2) nach einem der beiden vorhergehenden Ansprüche,
**dadurch gekennzeichnet,**
**dass** der Leiter (42) ein isolierter Draht, insbesondere ein Lackdraht ist.

7. Überwachungssystem (2) nach einem der vorhergehenden Ansprüche,
**dadurch gekennzeichnet,**
**dass** die beiden Elektroden (30) konzentrisch angeordnet sind und einen Zylinderkondensator (28) bilden.

8. Überwachungssystem (2) nach einem der vorhergehenden Ansprüche,
**dadurch gekennzeichnet,**
**dass** zwischen dem Leiter (42) und einer oder jeweils einer der Elektroden (30) eine Zwischenlage (44) aus einem isolierenden Material angeordnet ist, insbesondere aufextrudiert ist, zur galvanischen Trennung des Leiters (42) von den Elektroden (30).

9. Überwachungssystem (2) nach einem der vorhergehenden Ansprüche,
**dadurch gekennzeichnet,**
**dass** eine der Elektroden (30) als Geflecht (40) aus einem leitenden Material ausgebildet ist.

10. Überwachungssystem (2) nach einem der vorhergehenden Ansprüche,
**dadurch gekennzeichnet,**
**dass** eine der Elektroden (30) eine leitende Schicht (34) einer mehrschichtigen Folie (36) ist, die eine isolierende Trägerschicht (38) aufweist, auf welcher die leitende Schicht (34) aufgebracht ist, und
**dass** vorzugsweise die Trägerschicht (34) zum Leiter (42) hingewandt und zwischen diesem und der leitenden Schicht (34) angeordnet ist.

11. Überwachungssystem (2) nach einem der vorhergehenden Ansprüche,
**dadurch gekennzeichnet,**
**dass** die beiden Elektroden (30) jeweils als leitende Schicht (34) einer mehrschichtigen Folie (36) ausgebildet sind, mit einer Trägerschicht (38), wobei die beiden Trägerschichten (38) zum Leiter (42) hin orientiert sind und die leitenden Schichten (34) von diesem wegweisen.

12. Überwachungssystem (2) nach einem der vorhergehenden Ansprüche,
**dadurch gekennzeichnet,**
**dass** zwischen den beiden Elektroden (30) ein isolierendes Material angeordnet ist, das eine feuchtigkeits- und/oder temperaturabhängige Dielektrizitätszahl aufweist.

13. Überwachungssystem (2) nach einem der vorhergehenden Ansprüche,
**dadurch gekennzeichnet,**
**dass** zwischen den beiden Elektroden (30) ein hygroskopisches Material angeordnet ist.

14. Überwachungssystem (2) nach einem der vorhergehenden Ansprüche,
**dadurch gekennzeichnet,**
**dass** das Sicherheitskabel (6) als Datenkabel ausgebildet ist und/oder dass dieses in einem Bordnetz eines Fahrzeugs (4) verbaut ist und mittels des Sicherheitskabels (6) ein Fahrassistenzsystem (8) an das Bordnetz angeschlossen ist.

15. Verfahren zum Betrieb eines Überwachungssystems (2) gemäß einem der Ansprüche 1 bis 14, wobei
- eine Resonanzfrequenz der Ausfallsensorik (12) ermittelt wird,
- die Resonanzfrequenz mit einer vorgegebenen Normalfrequenz verglichen wird,
- ein Hinweis ausgegeben wird, falls die Resonanzfrequenz um einen vorgegebenen Mindestwert von der Normalfrequenz abweicht.

## Claims

1. Monitoring system (2) with a strand-form material (6), which comprises an internal structure along which a failure sensor system (12) extends, with a capacitor (28), which comprises two electrodes (30), and with an inductance (32), which is formed by a conductor (42) that is electrically connected to one of the electrodes (30) in such way that a series resonant circuit is formed
**characterized in**
**that** the two electrodes (30) are each designed as a shielding layer and completely enclose the internal structure.

2. Monitoring system (2) according to the preceding claim,
**characterized in**
**that** the conductor (42) is arranged between the electrodes (30).

3. Monitoring system (2) according to one of the preceding claims,
**characterized in**
**that** it comprises an analysis unit (16) with a printed circuit board, to which the failure sensor system (12) is connected, or that the safety cable (6) comprises a plug (18), by means of which the failure sensor system (12) can be connected to an analysis unit (16), for measuring a resonant frequency of the series resonant circuit.

4. Monitoring system (2) according to one of the preceding claims,
**characterized in**
**that** the conductor (42) is configured as a wire that is wound or spun in a plurality of windings around the internal structure.

5. Monitoring system (2) according to the preceding claim,
**characterized in**
**that** the windings are spaced apart from one another in a longitudinal direction (L) with a spacing (A), for setting a specific inductance value of the inductance.

6. Monitoring system (2) according to one of the two preceding claims,
**characterized in**
**that** the conductor (42) is an insulated wire, in particular an enamelled wire.

7. Monitoring system (2) according to one of the preceding claims,
**characterized in**
**that** the two electrodes (30) are arranged concentrically and form a cylindrical capacitor (28).

8. Monitoring system (2) according to one of the preceding claims,
**characterized in**
**that** between the conductor (42) and one or respectively one of the electrodes (30) an intermediate layer (44) of an insulating material is arranged, in particular extruded on, for the galvanic isolation of the conductor (42) from the electrodes (30).

9. Monitoring system (2) according to one of the preceding claims,
**characterized in**
**that** one of the electrodes (30) is configured as a braid (40) from a conductive material.

10. Monitoring system (2) according to one of the preceding claims,
**characterized in**
**that** one of the electrodes (30) is a conductive layer (34) of a multilayer foil (36), which comprises an insulating carrier layer (38) on which the conductive layer (34) is applied, and
**that** the carrier layer (34) preferably faces the conductor (42) and is arranged between said conductor and the conductive layer (34).

11. Monitoring system (2) according to one of the preceding claims,
**characterized in**
**that** the two electrodes (30) are each configured as a conductive layer (34) of a multilayer foil (36), with a carrier layer (38), wherein the two carrier layers (38) are oriented towards the conductor (42) and the conductive layers (34) faces away from said conductor.

12. Monitoring system (2) according to one of the preceding claims,
**characterized in**
**that** an insulating material is arranged between the two electrodes (30) that comprises a moisture and temperature dependent dielectric constant.

13. Monitoring system (2) according to one of the preceding claims,
**characterized in**
**that** a hygroscopic material is arranged between the two electrodes (30).

14. Monitoring system (2) according to one of the preceding claims,
**characterized in**
**that** the safety cable (6) is configured as a data cable and/or that it is installed in an on-board electrical system of a vehicle (4) and a driver assistance system (8) is connected to the on-board electrical system by means of the safety cable (6).

15. Method for operating a monitoring system (2) according to one of claims 1 to 14, wherein
- a resonance frequency of the failure sensor (12) is determined,
- the resonance frequency is compared to a given normal frequency,
- a message is displayed if the resonance frequency deviates from the normal frequency by a specified minimum value.

## Revendications

1. Système de surveillance (2) avec un matériau de coulée continue (6), qui comporte une structure interne le long de laquelle s'étend un système de détection de défaillance (12), avec un condensateur (28), qui comporte deux électrodes (30), et avec une inductance (32), qui est formée par un conducteur (42) qui est relié électriquement à l'une des électrodes (30) de telle sorte qu'un circuit résonnant en série est configuré
**caractérisé en ce**
**que** les deux électrodes (30) sont chacune conçues comme une couche de blindage et entourent complètement la structure interne.

2. Système de surveillance (2) selon la revendication précédente,
**caractérisé en ce**
**que** le conducteur (42) est disposé entre les électrodes (30).

3. Système de surveillance (2) selon l'une des revendications précédentes,
**caractérisé en ce**
**qu'**il comporte une unité d'analyse (16) avec une carte de circuit imprimé, à laquelle le système de détection de défaillance (12) est connecté, ou en ce que le câble de sécurité (6) comporte une fiche (18), au moyen de laquelle le système de détection de défaillance (12) peut être connecté à une unité d'analyse (16), pour mesurer une fréquence de résonance du circuit résonnant en série.

4. Système de surveillance (2) selon l'une des revendications précédentes,
**caractérisé en ce**
**que** le conducteur (42) est formé d'un fil enroulé ou filé en plusieurs enroulements autour de la structure interne.

5. Système de surveillance (2) selon la revendication précédente,
**caractérisé en ce**
**que** les enroulements sont espacés les uns des autres dans une direction longitudinale (L) avec un espacement (A), pour fixer une valeur d'inductance spécifique de l'inductance.

6. Système de surveillance (2) selon l'une des deux revendications précédentes,
**caractérisé en ce**
**que** le conducteur (42) est un fil isolé, en particulier un fil émaillé.

7. Système de surveillance (2) selon l'une des revendications précédentes,
**caractérisé en ce**
**que** les deux électrodes (30) sont disposées concentriquement et forment un condensateur cylindrique (28).

8. Système de surveillance (2) selon l'une des revendications précédentes,
**caractérisé en ce**
**qu'**entre le conducteur (42) et une ou respectivement l'une des électrodes (30) une couche intermédiaire (44) en un matériau isolant est disposée, en particulier extrudée, pour l'isolation galvanique du conducteur (42) par rapport aux électrodes (30).

9. Système de surveillance (2) selon l'une des revendications précédentes,
**caractérisé en ce**
**que** l'une des électrodes (30) est conçue comme une tresse (40) en un matériau conducteur.

10. Système de surveillance (2) selon l'une des revendications précédentes,
**caractérisé en ce**
**que** l'une des électrodes (30) est une couche conductrice (34) d'un film multicouche (36), qui comporte une couche de support isolante (38), sur laquelle est appliquée la couche conductrice (34), et
**que**, de préférence, la couche de support (34) fait face au conducteur (42) et est disposée entre ledit conducteur et la couche conductrice (34).

11. Système de surveillance (2) selon l'une des revendications précédentes,
**caractérisé en ce**
**que** les deux électrodes (30) sont chacune conçues comme une couche conductrice (34) d'un film multicouche (36), avec une couche de support (38), les deux couches de support (38) étant orientées vers le conducteur (42) et les couches conductrices (34) étant orientées à l'opposé de dudit conducteur.

12. Système de surveillance (2) selon l'une des revendications précédentes,
**caractérisé en ce**
**qu'**un matériau isolant est disposé entre les deux électrodes (30), qui comporte une constante diélectrique dépendant de l'humidité et de la température.

13. Système de surveillance (2) selon l'une des revendications précédentes,
**caractérisé en ce**
**qu'**un matériau hygroscopique est disposé entre les deux électrodes (30).

14. Système de surveillance (2) selon l'une des revendications précédentes,
**caractérisé en ce**
**que** le câble de sécurité (6) est conçu comme un câble de données et/ou qu'il est installé dans un système électrique de bord d'un véhicule (4) et qu'un système d'assistance au conducteur (8) est connecté au système électrique de bord au moyen du câble de sécurité (6).

15. Procédé pour le fonctionnement d'un système de surveillance (2) selon l'une des revendications 1 à 14, dans lequel
- une fréquence de résonance du capteur de défaillance (12) est déterminée,
- la fréquence de résonance est comparée à une fréquence normale spécifiée,
- un message est émis si la fréquence de résonance s'écarte de la fréquence normale d'une valeur minimale spécifiée.
